# EUROPEAN PATENT SPECIFICATION

(11) **EP 2 994 942 B1**
(45) Date of publication and mention of the grant of the patent: **07.09.2022**
(21) Application number: 14794388.0
(22) Date of filing: 25.04.2014
(51) Int. Cl.: H01B 1/22, H01L 31/0224

(54) **METHOD OF MANUFACTURING ELECTRODE OF SOLAR CELL**
VERFAHREN ZUR HERSTELLUNG EINER ELEKTRODE EINER SOLARZELLE
PROCÉDÉ DE FABRICATION D'UNE ÉLECTRODE DE CELLULE SOLAIRE

(30) Priority: 06.05.2013 KR 20130050834
(43) Date of publication of application: 16.03.2016
(73) Proprietor: Hanwha Chemical Corporation, Seoul 04541 (KR)
(72) Inventor: SIM, You-Jin, Daejeon 305-720 (KR); KIM, Eui-Duk, Daejeon 305-720 (KR); PAIK, Choong-Hoon, Daejeon 305-720 (KR); OH, Seok-Heon, Daejeon 305-720 (KR)
(74) Representative: Alt, Michael
(86) International application number: PCT/KR2014/003669
(87) International publication number: WO 2014/181985

(56) References cited:
- EP-A2- 2 290 705
- WO-A1-2010/135496
- KR-A- 20100 075 218
- KR-A- 20130 007 509
- KR-B1- 101 005 005
- KR-B1- 101 139 459
- US-A1- 2009 211 626
- US-A1- 2010 154 875
- US-A1- 2011 318 872

## Description

### [Technical Field]

The present invention relates to a method of manufacturing an electrode of a solar cell using a conductive paste composition having excellent dispersion stability and electrical conductivity as claimed in claim 1. Also described is a solar cell using the same.

The present application claims the priority benefits from Korean Patent Application No. 10-2013-0050834 filed on May 6, 2013.

### [Background Art]

Recently, with the prediction of exhaustion of the exiting energy resources such as petroleum, coal and the like, alternative energy sources thereto have attracted considerable attention. Among these alternative energy sources, a solar cell, directly converting soar energy into electric energy, has been in the limelight as a next-generation cell using a semiconductor device.

Solar cells are largely classified into silicon solar cells, compound-semiconductor solar cells and tandem solar cells. Among these solar cells, silicon solar cells are most frequently used.

Generally, such a silicon solar cell includes: a semiconductor substrate and a semiconductor emitter layer which are composed of P-type and N-type semiconductors having different conductive types from each other, an anti-reflective coating film formed on the semiconductor emitter layer; a conductive electrode layer formed on the anti-reflective coating film; a front electrode formed on the conductive electrode layer; and a rear electrode formed on the other side of the semiconductor substrate. Therefore, a P-N junction is formed at the interface between the semiconductor substrate and the semiconductor emitter layer.

In such a silicon solar cell, the transparent conductive electrode layer provided thereon with the front electrode is formed by the interfacial reaction between metal paste and the anti-reflective coating film. In this case, when silver included in the metal paste is liquefied at high temperature and then recrystallized into a solid phase, it makes contact with the semiconductor emitter layer by a punch through phenomenon in which the recrystallized silver penetrates the anti-reflective coating film through the intermediary of glass frit powder. The glass frit powder causes an interfacial reaction with the anti-reflective coating film so as to etch the anti-reflective coating film. This interfacial reaction is an oxidation-reduction reaction, and, through this reaction, some elements are reduced into byproducts. Therefore, in a conventional process of forming a front electrode using silver-containing paste by screen printing, a predetermined amount of glass frit is included in the silver-containing paste in order to penetrate the anti-reflective coating film at the time of forming a front electrode. However, when glass frit is included in the paste, there are problems in that it has a negative influence upon the electrical conductivity of the front electrode, and the dispersion stability of the paste also becomes poor.

Therefore, it is necessary to develop a novel method of manufacturing a front electrode of a solar cell, by which the adhesivity between an emitter layer and a transparent electrode layer can be increased, and the electrical conductivity of a solar cell and the dispersion stability of metal paste for forming a conductive layer can be improved.

US2011/318872 discloses a silicon solar cell which includes a first silicon layer with an emitter layer which has a thickness in a range of 50 nanometers to few hundreds nanometers. The emitter layer has at least one region which is porosified by chemical or electrochemical etching, wherein at least one part of the porosified region is embodied as metal silicide layer. A second silicon layer is disposed underneath the emitter layer, with the metal silicide extending from a top side of the emitter layer in a direction to the second silicon layer. At least one metal layer is applied on the metal silicide layer.

### [Disclosure]

### [Technical Problem]

It is an object of the present invention is to provide a method of manufacturing an electrode of a solar cell, wherein an electrode is formed on a metal silicide layer using a conductive paste composition including no glass frit or a minimum amount of glass frit, thus having excellent the dispersion stability of metal paste and improving the electrical conductivity of a solar cell, and to provide a solar cell using the method.

### [Technical Solution]

In order to accomplish the above object, an aspect of the present invention provides a method of manufacturing an electrode of a solar cell, including the steps of: forming an emitter layer on a substrate; forming an anti-reflective coating film on the emitter layer, removing a partial region of the anti-reflective coating film to form an opening; forming a first conductive layer directly connected with the emitter layer in the opening of the anti-reflective coating film; and forming a second conductive layer on the first conductive layer, wherein the second conductive layer is formed by printing a conductive paste composition on the first conductive layer, wherein the conductive paste composition includes 60 to 95 wt% of metal powder, 0 to 0.5 wt% of glass frit, 1 to 20 wt% of a binder and 1 to 20 wt% of a solvent, wherein the glass frit have an average particle diameter (D₅₀) of 0.5 to 10 µm, wherein the metal particles of the second conductive layer are included in the first conductive layer in an amount of 2 to 10 parts by weight, based on 100 parts by weight of the metal particles of the first conductive layer.

In the method, the metal powder includes metal particles having an average particle diameter (D₅₀) of 0.5 to 4 µm, selected from the group consisting of Ag, Au, Al, Ni, Pt, Cu, and alloys thereof. The metal powder may include sphere-shaped or flake-shaped Ag powder having an average particle diameter (D₅₀) of 0.5 to 4 µm.

Further, the glass frit may include 5 to 30 wt% of SiO₂, 50 to 90 wt% of PbO, 0.1 to 10 wt% of Al₂O₃ and 0.1 to 10 wt% of ZrO₂. Selectively, the glass frit may further include ZnO and Li₂O, and the composition thereof may include 5 to 30 wt% of SiO₂, 50 to 90 wt% of PbO, 0.1 to 10 wt% of Al₂O₃ and 0.1 to 10 wt% of ZrO₂, 0.1 to 10 wt% of ZnO and 0.1 to 10 wt% of Li₂O.

Further, the binder may include: a carboxyl-containing photosensitive resin which is a copolymer of an unsaturated carboxylic compound and a compound having an unsaturated double bond; a carboxyl-containing photosensitive resin which obtained by adding an ethylenically unsaturated group, as a pendant group, to a copolymer of an unsaturated carboxylic compound and a compound having an unsaturated double bond; and a carboxyl-containing photosensitive resin which obtained by a reaction of a copolymer of an unsaturated carboxylic compound and a compound having an unsaturated double bond with a compound having a hydroxyl group and an unsaturated double bond.

The solvent may include at least one selected from the group consisting of α-terpineol, butyl carbitol acetate, texanol, butyl carbitol, and dipropylene glycol monomethyl ether.

The second conductive layer may be formed by electrohydrodynamic printing, screen printing, inkjet printing, dispensing printing or plating.

The first conductive layer may be a metal silicide layer including metal particles selected from the group consisting of Ni, Ti, Co, Pt, Pd, Mo, Cr, Cu, W, and alloys thereof.

The method may further include the step of performing a firing process at a temperature of 400°C to 980°C for 0.1 to 20 min after the formation of the first conductive layer and the second conductive layer.

The opening may be formed by photolithography, laser etching or an etching paste method.

Another aspect provides a solar cell, including: a substrate; an emitter layer formed on one side of the substrate; an anti-reflective coating film formed on the emitter layer; a front electrode penetrating the anti-reflective coating film to be connected to the emitter layer; and a rear electrode formed on the other side of the substrate, wherein, according to the method, the front electrode includes: a first conductive layer formed in the opening of the anti-reflective coating film and directly connected with the emitter layer; and a second conductive layer formed on the first conductive layer.

### [Advantageous Effects]

According to the present invention, when a front electrode is manufactured by forming a second conductive layer on a first conductive layer (metal silicide layer) using a conductive past composition containing no glass frit or a minimum amount of glass frit, the dispersion stability of metal paste is improved compared to that of conventional metal paste, thus improving the electrical conductivity of a solar cell. Therefore, the present invention provides a solar cell having high adhesivity between an emitter layer and a transparent conductive layer and having low contact resistance and high photovoltaic power generation efficiency.

### [Description of Drawings]

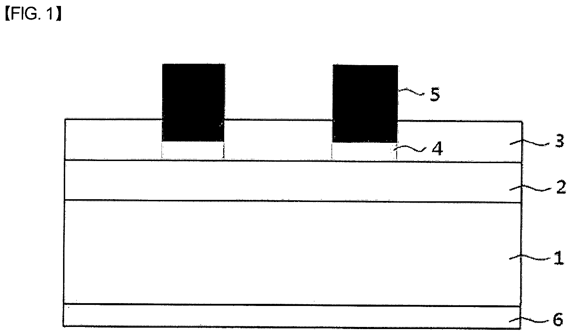

FIG. 1 is a schematic sectional view showing a structure of a solar cell according to an embodiment of the method of the present invention.

### [Reference Numerals]

1: silicon semiconductor substrate
2: emitter layer
3: anti-reflective coating film
4: first conductive layer of front electrode
5: second conductive layer of front electrode
6: rear electrode

### [Best Mode]

Hereinafter, a method of manufacturing an electrode of a solar cell according to an embodiment of the present and a solar cell using the same will be described in detail.

The method of manufacturing an electrode of a solar cell according to an embodiment of the present invention includes the steps of: forming an emitter layer on a substrate; forming an anti-reflective coating film on the emitter layer; removing a partial region of the anti-reflective coating film to form an opening; forming a first conductive layer directly connected with the emitter layer in the opening of the anti-reflective coating film; and forming a second conductive layer on the first conductive layer, wherein the second conductive layer is formed by printing a conductive paste composition on the first conductive layer, the conductive paste composition including 60 to 95 wt% of metal powder, 0 to 0.5 wt% of glass frit, 1 to 20 wt% of a binder and 1 to 20 wt% of a solvent, wherein the glass frit have an average particle diameter (D₅₀) of 0.5 to 10 µm, wherein the metal particles of the second conductive layer are included in the first conductive layer in an amount of 2 to 10 parts by weight, based on 100 parts by weight of the metal particles of the first conductive layer, wherein the metal powder includes metal particles having an average particle diameter (D₅₀) of 0.5 to 4 µm, selected from the group consisting of Ag, Au, Al, Ni, Pt, Cu, and alloys thereof.

The method of manufacturing an electrode of a solar cell according the present invention is characterized in that a specific conductive paste composition including no glass frit or including a very small amount of glass frit is used in forming the second conductive layer on the first conductive layer (metal silicide layer).

When a conductive electrode layer is formed on the metal silicide layer in this way, the content of glass frit in the conductive paste composition is small, so the dispersion stability of the conductive paste composition is excellent, and the content of glass frit, having non-conducting properties, decreases and the content of silver (Ag) increases, thus improving the electrical characteristics thereof. Further, when the conductive paste composition of the present invention is used, the effect of reducing silver (Ag) by primary lower printing and secondary upper printing at the time of forming the conductive electrode layer can be expected. In addition, if the composition of the present invention is used to form the conductive layer, the effect of reducing silver (Ag) can be expected by the primary lower printing and the second upper printing process.

The conductive paste composition used in the present invention essentially includes metal powder, a binder and a solvent, and may further include a minimum amount of glass frit.

Preferably, the conductive paste composition used in forming the second conductive layer may include 60 to 95 wt% of metal powder, 0 to 0.5 wt% of glass frit, 1 to 20 wt% of a binder, 1 to 20 wt% of a solvent and 0.01 to 5 wt% of an additive.

Hereinafter, the ingredients included in the conductive paste composition of the present invention will be described in more detail, respectively.

### Metal powder

The conductive paste composition of the present invention includes metal powder as conductive powder for conferring electrical characteristics.

The metal powder includes metal particles having an average particle diameter (D₅₀) of 0.5 to 4 µm, selected from the group consisting of Ag, Au, Al, Ni, Pt, Cu, and alloys thereof. Preferably, the metal powder may include sphere-shaped or flake-shaped Ag powder having an average particle diameter (D₅₀) of 0.5 to 4 µm.

Specifically, in the present invention, the silver (Ag) powder may include silver oxide, silver alloy, and other materials capable of precipitating silver powder by firing as well as pure silver (Ag) powder. These materials may be used independently or in a mixture thereof.

The silver powder may be commercially-available sphere-shaped or flake-shaped silver powder. The flake-shaped silver powder may be formed by a commonly-used method.

According to an embodiment of the present invention, the silver powder may have an average particle diameter (D₅₀) of 0.5 to 4 µm.

Further, the purity of the silver powder is not particularly limited as long as it satisfies general requirements necessary as an electrode. The purity of the silver powder used in the present invention may be 90% or more, preferably, 95% or more.

The amount of the metal powder in the conductive paste composition of the present invention may be 60 to 95 wt%, preferably, 80 to 95 wt%, based on the total weight of the conductive paste composition. When the amount of the metal powder is less than 60 wt%, the conductive paste composition is phase-separated, or the viscosity thereof is lowered, thus causing a problem of printability. Further, when the amount thereof is more than 95 wt%, the viscosity of the conductive paste composition becomes high, and thus it is difficult to print this composition.

### Glass frit

In the conductive paste composition used in forming the second conductive layer, the amount of glass frit is 0 to 0.5 wt%, based on the total weight of the conductive paste composition.

The conductive paste composition of the present invention may not include glass frit at all or may include a very small amount of glass frit, thus making the contact between an electrode layer and a silicon layer easy due to the formation of the first conductive layer (metal silicide layer). Further, thanks to the presence of glass frit, the dispersion stability of the conductive paste composition is improved, thus greatly improving the printability thereof.

Glass frit is used to effectively make an electrode into a fired pattern having no pinhole, and may include SiO₂, PbO and at least one metal oxide selected from the group consisting of Al₂O₃, ZrO₂, ZnO and Li₂O.

More specifically, according to an embodiment of the present invention, the glass frit may be a glass composition including 5 to 30 wt% of SiO₂, 50 to 90 wt% of PbO, 0.1 to 10 wt% of Al₂O₃ and 0.1 to 10 wt% of ZrO₂.

According to another embodiment of the present invention, the glass frit may be a glass composition including 5 to 30 wt% of SiO₂, 50 to 90 wt% of PbO, 0.1 to 10 wt% of Al₂O₃ and 0.1 to 10 wt% of ZrO₂, 0.1 to 10 wt% of ZnO and 0.1 to 10 wt% of Li₂O.

The Al₂O₃, ZrO₂, ZnO and Li₂O included in the glass frit serves to maintain low viscosity as well as form a stable glass phase during an interfacial reaction. When a glass ingredient has low viscosity during the interfacial reaction, the probability of contact between PbO and an anti-reflective coating film becomes high, and thus etching may take place in a larger area. As such, when etching takes place relatively frequently, the area of a front electrode formed by the recrystallization of metal powder (preferably, Ag powder) becomes larger, so the contact resistance between a substrate and a front electrode becomes lower, thereby improving the performance of a solar cell and enhancing the contact strength between the substrate and the front electrode.

Further, the glass frit may further include ingredients generally used in the glass composition in addition to the above ingredients. Such ingredients may be used regardless of kind, and all the ingredients well known in the related field may be used. For example, the glass frit may further include, but is not limited to, Na₂O.

Further, according to an embodiment of the present invention, the glass frit have an average particle diameter (D₅₀) of 0.5 to 10 µm, preferably, 0.8 to 5 µm. When the average particle diameter of the glass frit is present within the above range, an electrode can be effectively made into a fired pattern having no pinhole. Therefore, it is preferred that the average particle diameter thereof be present within the above range.

Meanwhile, the glass frit is used in the form of solid powder after its ingredients are melted and then solidified and powdered through a series of procedures below.

According to an embodiment of the present invention, when the ingredients of the glass frit are melted together under the atmospheric pressure, the intermolecular bonds of the ingredients are cut, so these ingredients lose the properties of metal oxide, are uniformly mixed in a molten state, and have vitreous properties after the following cooling process. In the melting process of the ingredients, the melting temperature thereof is not particularly limited as long as each of the ingredients can be sufficiently melted at this melting temperature. For example, the melting temperature may be 900 to 1,500 °C, but is not limited thereto. Further, the melting time thereof is not particularly limited as long as all the ingredients can be sufficiently melted for the melting time while maintaining the above melting temperature. The melting time may be suitably selected depending on the kinds of the ingredients and the melting temperature thereof. For example, the melting time may be 10 min to 1 hr, but is not limited thereto.

Next, the molten mixture is cooled to obtain solid glass frit. That is, the molten ingredients are hardened through a cooling process to form sold glass frit. The cooling rate may be suitably selected depending on the kinds of the ingredients of the glass frit, but, preferably, the ingredients may be rapidly cooled. Specific cooling conditions may be determined with reference to the state diagram of each of the ingredients. When the cooling rate is excessively low, the crystallization of the molten ingredients occurs, and thus a glass phase may not be formed. For example, the molten mixture maybe cooled to 25 ~ 50 °C for 1 to 5 min under the atmospheric pressure, but is not limited thereto. In order to obtain the above high cooling rate, methods generally used in the related field may be used without limitations. For example, a method of extruding the molten mixture into a sheet to increase surface area and a method of precipitating the molten mixture with water may be employed, but is not limited thereto.

Next, the solid glass frit is pulverized into glass frit powder. Since the above-mentioned glass frit is too large in volume to mix with metal paste, it is preferred that this glass frit be pulverized into glass frit powder. After the pulverization of the solid glass frit, the average particle diameter of the obtained glass frit powder may be 1 to 10 µm, but is not limited thereto. When the average particle diameter thereof is present within the above range, the glass frit powder is uniformly dispersed in the metal paste, thus very efficiently causing an interfacial reaction. As the method of pulverizing the solid glass frit obtained by cooling into glass frit powder, pulverization method generally used in the related field may be used without limitations. For efficient pulverization, the pulverization process may be performed in two stages. In this case, the primary and secondary pulverizations may be repeatedly performed in the same manner; and the primary pulverization may be performed by coarse pulverization, and the secondary pulverization may be performed by fine pulverization. Here, the coarse pulverization means that the above-mentioned solid glass frit is pulverized to a proper in order to make the fine pulverization thereof easy, not that the average particle diameter of the glass frit powder obtained thereby is limited to a predetermined average particle diameter. The fine pulverization is a process of pulverizing the coarsely pulverized glass frit into glass frit powder having a desired average particle diameter. Further, if necessary, each of the primary and secondary pulverization processes may be selectively performed by either dry pulverization or wet pulverization. As generally known in the related field, in wet pulverization, water, ethanol or the like may be added, but is not limited thereto.

### Binder

The conductive paste composition of the present invention includes a binder.

The binder functions to bind the ingredients before the firing of an electrode pattern, and, for uniformity, may be prepared by suspension polymerization.

The binder may include carboxyl-containing resins, for example, a carboxyl-containing photosensitive resin having an ethylenically unsaturated double bond and a carboxyl-containing photosensitive resin having no ethylenically unsaturated double bond. More specifically, the binder may include, but is not limited to: a carboxyl-containing photosensitive resin which is a copolymer of an unsaturated carboxylic compound and a compound having an unsaturated double bond; a carboxyl-containing photosensitive resin which obtained by adding an ethylenically unsaturated group, as a pendant group, to a copolymer of an unsaturated carboxylic compound and a compound having an unsaturated double bond; and a carboxyl-containing photosensitive resin which obtained by a reaction of a copolymer of an unsaturated carboxylic compound and a compound having an unsaturated double bond with a compound having a hydroxyl group and an unsaturated double bond.

The binder may be included in an amount of 1 to 20 wt%, based on the total weight of the conductive paste composition. The amount of the binder is less than 1 wt%, the distribution of the binder in the formed electrode pattern may become ununiform, and thus the patterning cannot be easily performed by selective exposure and development. In contrast, when the amount thereof is more than 20 wt%, a pattern may be easily destroyed at the time of firing an electrode, and the resistance of the electrode may be increased by carbon ash after firing the electrode.

### Solvent

The conductive paste composition includes a solvent.

The solvent can dissolve the binder, and can be easily mixed with other additives. Examples of the solvent may include, but are not limited to, α-terpineol, butyl carbitol acetate, texanol, butyl carbitol, and dipropylene glycol monomethyl ether.

The solvent may be included in an amount of 1 to 20 wt%, based on the total weight of the conductive paste composition. When the amount of the solvent is less than 1 wt%, it is difficult to uniformly apply the conductive paste composition. In contrast, when the amount thereof is more than 20 wt%, an electrode pattern having sufficient conductivity cannot be obtained, and the adhesivity between the conductive paste composition and the substrate may be deteriorated.

### Additives

The conductive paste composition of the present invention may further include an additive, such as a dispersant, a thickener, a thixotropic agent, a leveling agent or the like, in addition to the above-mentioned ingredients. The additive, if necessary, may be included in an amount of 0 to 5 wt%, based on the total weight of the conductive paste composition.

Examples of the dispersant may include, but are not limited to, DISPERBYK-180, 110, 996, and 997, manufactured by BYK Corporation.

Examples of the thickener may include, but are not limited to, BYK-410, 411 and 420, manufactured by BYK Corporation.

Examples of the thixotropic agent may include, but are not limited to, ANTI-TERRA-203, 204 and 205, manufactured by BYK Corporation.

Examples of the leveling agent may include, but are not limited to, BYK-3932 P, BYK-378, BYK-306 and BYK-3440, manufactured by BYK Corporation.

Hereinafter, the method of manufacturing an electrode of a solar cell according to the present invention will be described in detail.

The solar cell includes a substrate, an emitter layer, an anti-reflective coating film and a conductive layer. Here, the conductive layer may be a front electrode. The conductive layer may have a multi-layered structure including a first conductive layer and a second conductive layer.

Further, in the present invention, when the conductive layer has a multi-layered structure, the first conductive layer making contact with the emitter layer does not include glass frit, and the second conductive layer formed on the first conductive layer does not include glass frit or include a very small amount of glass frit. According to the present invention, the effect of reducing silver (Ag) can be expected by primary lower printing and secondary upper printing at the time of forming a conductive electrode layer.

According to an embodiment of the present invention, the conductive layer may include a first conductive layer, as a silicide layer, and a second conductive layer formed of the above mentioned conductive paste composition of the present invention.

For this purpose, first, a substrate is provided, and then an emitter layer is formed on the substrate.

The emitter layer may be formed by a method well known in the related field. Therefore, the method of forming the emitter layer is not limited.

Subsequently, an anti-reflective coating (ARC) film is formed on the emitter layer.

Specifically, the process of forming the anti-reflective coating film on the emitter layer may be performed using a general electrode preparation process. Here, the substrate may be doped with a P-type impurity, and the emitter layer may be doped with an N-type impurity.

The anti-reflective coating film may be a single-layer film or multi-layer film made of any one selected from the group consisting of silicon nitride, hydrogen-containing silicon nitride, silicon oxide, MgF₂, ZnS, TiO₂, CeO₂, and mixtures thereof.

Subsequently, a partial region of the anti-reflective coating film is removed to form an opening therein.

In this method, the opening may be formed by photolithography, laser etching or an etching paste method. Preferably, the opening may be formed by electrohydrodynamic printing using etching paste or screen printing using etching paste. More preferably, the opening may be formed by electrohydrodynamic printing using etching paste. The process of forming the opening using photolithography or laser printing may be performed by a generally known method, and is not particularly limited.

When the opening is formed using the etching paste, specifically, the etching paste is printed on the anti-reflective coating film, and then the anti-reflective coating film printed with the etching paste is immersed into a 0.1% KOH solution and partially removed using ultrasonic waves.

The size and shape of the opening of the anti-reflective coating film must correspond to the size and shape of the conductive layer. The reason for this is that the conductive layer is formed in the opening of the anti-reflective coating (ARC) film to directly make contact with the emitter layer to form a silicide compound. For example, the shape of the opening corresponds to the shape of an electrode, and the anti-reflective coating film may be removed along the line width of the electrode, for example, a line width of 60 µm.

When a composition for forming a conductive layer is printed in the opening of the anti-reflective coating film by electrohydrodynamic printing to form a conductive layer, the conductive layer directly makes contact with the emitter layer to form a silicide compound, thereby reducing the contact resistance of an electrode.

Next, the first conductive layer, which is a silicide layer directly making contact with the emitter layer, is formed in the opening of the anti-reflective coating film.

The first conductive layer may be formed on the opening of the anti-reflective layer by electrohydrodynamic printing such that it directly makes contact with the emitting layer without an additional intermediate layer.

The conductive layer may be formed by non-contact direct printing, preferably, electro-hydrodyanmic printing. The eletrohydrodynamic printing is a technology of injecting droplets using an electric field. In the electrohydrodynamic printing, when a predetermined voltage is applied between an injection nozzle and a substrate, an electric field is generated, and simultaneously electric charges are concentrated on the surface of fluid around the injection nozzle. In this case, when the pressure of fluid injected from the nozzle is higher than the surface tension of fluid due to the electric charges generated from the surface of fluid and the electric field, the spherical surface of fluid is converted into the Taylor cone-shaped surface thereof, and thus jet or spray droplets still smaller than the size of the nozzle are generated. Due to the formation of Taylor cone by the electric field, jet or spray droplets having a size of several hundreds of nanometers (nm) to several tens of micrometers (µm) can be generated from the nozzle having a relative large size of several tens of micrometers (µm) to several hundreds of micrometers (µm), and thus two advantages of the improvement of line width resolution and the reduction of clogging frequency can be realized, and the linearity of the injected droplets can be improved by optimizing the electric field.

The electrohydrodynamic printing is advantageous in that the physical damage of a silicon substrate can be minimized because it is not necessary to form an electrode by pressuring the silicon substrate, similarly to screen printing, in that the consumption of raw material can be reduced, and in that an electrode can be formed using electrode materials having a wide viscosity range because the electrohydrodynamic printing process is not greatly influenced by the viscosity of the electrode material. For this reason, in the case of a nickel layer on which a thin electrode layer is to be applied, the thin electrode layer can be formed by printing low-viscosity ink, and, in the case of an Ag electrode that must have a high aspect ratio, this Ag electrode can be formed using high-viscosity ink. Therefore, electrohydrodynamic printing can overcome the limitations of ink-jet printing and screen printing.

Further, the metal particles applicable to the composition for forming the first conductive layer may be used without limitations as long as they are conductive metal particles capable of forming the emitting layer and the silicide compound. For example, when the conductive layer includes the first conductive layer making contact with the emitter layer and the second conductive layer formed on the first conductive layer, the first conductive layer may include metal particles selected from the group consisting of Ni, Ti, Co, Pt, Pd, Mo, Cr, Cu, W, and alloys thereof. Preferably, the first conductive layer may include nickel particles.

Further, the composition for forming the first conductive layer according to the present invention may be an ink composition, and may further include a solvent, a binder and a dispersant in addition to the metal particles. The generally used ingredients and contents are applicable even to the present invention.

For example, the binder functions to bind the ingredients before the firing of an electrode pattern, and, for uniformity, may be prepared by suspension polymerization. The binder may be used without limitations as long as it is a polymer that can be dissolved in a main solvent. Specifically, the binder may include carboxyl-containing resins, for example, a carboxyl-containing photosensitive resin having an ethylenically unsaturated double bond and a carboxyl-containing photosensitive resin having no ethylenically unsaturated double bond. Examples of the binder may include, but are not limited to, i) a carboxyl-containing photosensitive resin which is obtained by the copolymerization of an unsaturated carboxylic compound and a compound having an unsaturated double bond; ii) a carboxyl-containing photosensitive resin which obtained by adding an ethylenically unsaturated group, as a pendant group, to a copolymer of an unsaturated carboxylic compound and a compound having an unsaturated double bond; and iii) a carboxyl-containing photosensitive resin which obtained by a reaction of a copolymer of an unsaturated carboxylic compound and a compound having an unsaturated double bond with a compound having a hydroxyl group and an unsaturated double bond. These binders may be used independently or in a combination of two or more. The preferred examples of the binder may include an alkylphenolformaldehyde copolymer (for example, Tackirol, manufactured by Taoka Chemical Corporation), polyvinylpyrrolidone (PVP), polyvinyl alcohol (PVA), ethylcellulose, and the like.

The binder may be included in an amount of 0.1 to 5 wt%, based on the total weight of the composition for forming the first conductive layer. The amount of the binder is less than 0.1 wt%, the distribution of the binder in the formed electrode pattern may become non-uniform, and thus the patterning cannot be easily performed by selective exposure and development. In contrast, when the amount thereof is more than 5 wt%, a pattern may be easily destroyed at the time of firing an electrode, and the resistance of the electrode may be increased by carbon ash after firing the electrode.

The dispersant may be included in an amount of 0.5 to 5 wt%, based on the total weight of the composition for forming the first conductive layer. The dispersant may be a copolymer including an acid group having an acid value of 50 mg KOH/g or more and an amine value of 100 mg KOH/g or less. Examples of commercially available phosphate copolymers satisfying the above acid value and amine value may include BYK102 (acid value: 101 mg KOH/g, amine value: 0mg KOH/g), BYK110 (acid value: 53mg KOH/g, amine value: 0mg KOH/g), BYK145 (acid value: 76mg KOH/g, amine value: 71mg KOH/g), BYK180 (acid value: 94mg KOH/g, amine value: 94mg KOH/g), BYK995 (acid value: 53mg KOH/g, amine value: 0mg KOH/g), and BYK996(acid value: 71 mg KOH/g, amine value: 0mg KOH/g), which are manufactured by BYK Chemie Corporation.

As the solvent that can be used in the composition for forming the first conductive layer, all solvents generally used in forming a conductive electrode layer may be used as long as they can dissolve the binder and can be easily mixed with other additives. Preferably, the solvent may be a mixture of a low-boiling solvent, as a main solvent, and a high-boiling solvent.

The low-boiling solvent, as a main solvent, may be low-boiling glycol ethers each including a hydroxyl group at the end thereof and having a boiling point of 130°C to 210°C, preferably, 170 to 210°C. When the boiling point of the low-boiling solvent is lower than 130°C, the jetting characteristics of the composition for forming the first conductive layer become poor, and, when the boiling point thereof is higher than 210°C, the drying rate of the composition after jetting becomes low, and thus the spreading phenomenon thereof becomes severe.

The low-boiling solvent may be included in an amount of 30 to 70 wt%, based on the total weight of the composition for forming the first conductive layer. When the amount of the low-boiling solvent is less than 30 wt%, it is difficult to uniformly apply ink. In contrast, when the amount thereof is more than 70 wt%, an electrode pattern having sufficient conductivity cannot be obtained, and the adhesivity between the composition and the substrate may be deteriorated.

Preferred examples of the low-boiling solvent may include: diethylene glycol monoalkyl ethers, such as diethylene glycol monomethyl ether (methyl carbitol), diethylene glycol monoethyl ether (ethyl carbitol), diethylene glycol monobutyl ether (butyl carbitol) and the like; and ethylene glycol monoalkyl ethers, such as ethylene glycol ethyl ether (ethyl cellosolve), ethylene glycol propyl ether (propyl cellosolve), ethylene glycol n-butyl ether (n-butyl cellosolve)) and the like, wherein the alkyl is a straight-chained or branched alkyl group.

The high-boiling solvent may be a solvent including a hydroxyl group at the end thereof and having a boiling point of 240°C to 300°C, preferably, 240 to 270°C. Examples of the high-boiling solvent may include, but are not limited to, diethylene glycol, glycerol, and tripropylene glycol methyl ether.

The high-boiling solvent may be included in an amount of 3 to 10 wt%, based on the total weight of the composition for forming the first conductive layer. When the amount of the high-boiling solvent is less than 3 wt%, the jetting characteristics of the composition for forming the first conductive layer become poor, and, when the amount thereof is more than 10 wt%, the drying rate of the composition after jetting becomes low, and thus the spreading phenomenon thereof becomes severe.

Further, if necessary, the composition for forming the first conductive layer may further include at least one additive selected from among a thickener, a thixotropic agent and a leveling agent. The additive may be included in an amount of 1 to 20 wt%, based on the total weight of the composition for forming the first conductive layer.

In the method of preparing the composition for forming the first conductive layer according to the present invention, stirring and pulverization processes may be performed by ball milling, and a milling process may be performed in order to prepare glass frit nanoparticles. Additionally, a filtering process may be performed in order to remove coagulated particles or particles exceeding a predetermined diameter range. More preferably, this method may be performed by flame spray pyrolysis, plasma treatment or the like, but is not limited thereto.

The composition for forming the first conductive layer may also be used in forming a front electrode of a silicon solar cell. Metal powder, such as nickel powder, is bonded to silicon to form metal silicide, thus reducing the contact resistance between a silicon substrate and an electrode.

When the above procedures are completed, a second conductive layer is formed on the first conductive layer.

The second conductive layer may be formed by printing the above-mentioned conductive paste composition.

The printing method for forming the second conductive layer may be performed by screen printing, inkjet printing, dispensing printing, silver light induced plating (LIP), plating, such as electroless plate, or electrohydrodynamic printing. Preferably, the printing method for forming the second conductive layer may be performed by electrohydrodynamic printing.

The second conductive layer includes metal particles selected from the group consisting of Ag, Au, Al, Ni, Pt, Cu, and alloys thereof. Preferably, the second conductive layer may include silver particles.

In this case, the metal particles of the second conductive layer is included in the first conductive layer in an amount of 2 to 10 parts by weight, based on 100 parts by weight of the metal particles of the first conductive layer, thus increasing the adhesivity between the first conductive layer and the second conductive layer.

The method according to the present invention may further include the step of performing a firing process at a temperature of 400°C to 980°C for 0.1 to 20 min after the formation of the first conductive layer and the second conductive layer. When the conductive layer includes the first conductive layer and the second conductive layer, the firing processes may be respectively performed after the formation of each of the first and second conductive layers, or may be simultaneously formed after the formation of both the first conductive layer and the second conductive layer.

In the method, the thickness of the first conductive layer may be 50 nm to 1 µm. When the thickness of the first conductive layer is less than 50 nm, which is excessively thin, it is difficult to form a silicide layer, and thus the first conductive layer does not make contact with the emitting layer. Further, when the thickness thereof is more than 1 µm, which is excessively thick, the conductivity of the first conductive layer is not good compared to that of silver (Ag), and thus the resistance thereof increases, thereby blocking the flow of electric current.

Further, it is preferred that the upper part of the second conductive layer be exposed over the anti-reflective coating film through the opening formed in the anti-reflective coating film. The thickness of the second conductive layer may be 5 to 25 µm. When the thickness of the second conductive layer is less than 5 µm, the linear resistance thereof increases, thus decreasing electric current. Further, when the thickness thereof is more than 25 µm, the second conductive layer causes a shading phenomenon for blocking light, thus increasing the unit cost thereof.

Meanwhile, there is provided a solar cell, including: a substrate; an emitter layer formed on one side of the substrate; an anti-reflective coating film formed on the emitter layer, a front electrode penetrating the anti-reflective coating film to be connected to the emitter layer; and a rear electrode formed on the other side of the substrate, wherein, according to the method, the front electrode includes: a first conductive layer formed in the opening of the anti-reflective coating film and directly connected with the emitter layer, and a second conductive layer formed on the first conductive layer.

In the solar cell, as described above, a substrate (for example, silicon wafer) provided with an anti-reflective coating (ARC) film is etched by photolithography, laser etching or screen printing to form an opening, and then a silicide forming material is printed in the opening to form a front electrode.

Subsequently, a first conductive layer of the front electrode is formed using the silicide forming material, and then a second conductive layer of the front electrode is formed.

Thereafter, a rear electrode is formed by subsequent processes, and then co-firing is performed to manufacture a solar cell. Further, a silicide layer having low contact resistance at the interface of an electrode and an emitter layer is formed by the co-firing.

According to the method of the present invention, a solar cell having high efficiency can be manufactured by using an Ag electrode layer including a small amount of glass frit.

FIG. 1 is a schematic sectional view showing a structure of a solar cell according to a method of the present invention.

Referring to FIG. 1, The solar cell according to a method of the present invention includes a first conductive type silicon semiconductor substrate 1, a second conductive type emitter layer 2 formed on one side of the substrate 1, an anti-reflective coating film 3 formed on the emitter layer 2, a first conductive layer 4 penetrating the anti-reflective coating film 3 to be directly connected to the emitter layer 2, a second conductive layer 5 formed on the first conductive layer 4 using a conductive paste composition, and a rear electrode 6 formed on the other side of the substrate 1.

In the structure of the solar cell, a part of the first conductive layer 4 directly makes contact with the emitter layer 2 through at least one opening formed in the anti-reflective coating film 3 to be electrically connected with the emitter layer 2.

Further, the upper part of the second conductive layer 5 may be exposed over the anti-reflective coating film 3 through at least one opening formed in the anti-reflective coating film 3, and the lower part thereof may make contact with the first conductive layer 4.

In this case, the substrate 1 may be doped with a P-type impurity, such as Group III elements including B, Ga, In and the like, and the emitter layer 2 may be doped with an N-type impurity such as group V elements including P, As, Sb and the like. Like this, when the substrate 1 and the emitter layer 2 are respectively doped with conductive impurities opposite to each other, a P-N junction is formed at the interface between the substrate 1 and the emitter layer 2.

The anti-reflective coating film 3 serves to immobilize the defects existing on the surface of the emitter layer 2 or in the bulk thereof and decrease the reflectance of solar light incident on the front side of the substrate 1. When the defects existing in the emitter layer 2 is immobilized, the recombination sites of a minority carrier are removed, and thus the open voltage (Voc) of a solar cell increases. Further, when the reflectance of solar light decreases, the amount of light reaching the P-N junction increases, and thus the short-circuit current (Isc) of a solar cell increases. As such, when the open voltage and short-circuit current of a solar cell are increased by the anti-reflective coating film 3, the conversion efficiency thereof is increased in proportion thereto.

Meanwhile, as shown in FIG. 1, the front electrode is located at the uppermost portion of a solar cell to block solar light. Thus, it is important to minimize the area of the front electrode without deteriorating the function thereof.

Further, the rear electrode 6 may include, but is not limited to, aluminum. For example, the rear electrode 6 may be formed by printing the other side of the substrate 1 with an ink composition including aluminum, quartz, silica, a binder and the like and then heat-treating the ink composition. During the heat treatment of the rear electrode, aluminum, which is an electrode forming material, is diffused through the back side of the substrate 1, and thus a back surface field layer may be formed at the interface of the rear electrode 6 and the substrate 1. When the back surface field layer is formed, it is possible to prevent carriers from being recombined by the movement thereof toward the back side of the substrate 1, and, when the recombination of the carriers is prevented, the open voltage of a solar cell increases, thus improving the efficiency of a solar cell.

### [Mode for Invention]

Hereinafter, the present invention will be described in more detail with reference to the following Examples.

### <Preparation Example 1>

SiO₂ 17.0 wt%, Al₂O₃ 8.7 wt%, PbO 66.0 wt%, ZnO 6.0 wt%, Li₂O 1.7 wt%, and ZrO₂ 0.6 wt% were mixed using a ball mill, and then dried at 80°C. This mixture was melted at 1000°C, and then quenched at room temperature. This resulting mixture was coarsely pulverized using a disk mill, and then finely pulverized using a planetary mill to prepare glass frit having an average particle size of 5 µm or less.

### <Preparation Example 2>

SiO₂ 17.0 wt%, Al₂O₃ 10.75 wt%, PbO 64.55 wt%, ZnO 6.0 wt%, and B₂O₃ 1.7 wt% were mixed using a ball mill, and then dried at 80°C. This mixture was melted at 1000°C, and then quenched at room temperature. This resulting mixture was coarsely pulverized using a disk mill, and then finely pulverized using a planetary mill to prepare glass frit having an average particle size of 5 µm or less.

### <Examples 1 to 3 and Comparative Examples 1 to 3>

Silver paste compositions were prepared according to the ingredients and contents (unit: wt%) given in Table 1 below.

In this case, as silver (Ag) powder, Ag particles (brand name: 4-8F, manufactured by Dowa Corporation) having an average particle diameter (D₅₀) of 2.0 µm and Ag particles (brand name: 2-1C, manufactured by Dowa Corporation) having an average particle diameter (D₅₀) of 0.8 µm were used.

Further, ethylcellulose (Std 10, manufactured by Dow Chemical Corporation) was used as a binder, BCA (butyl carbitol acetate) was used as a solvent, and a dispersant (KD-4, manufactured by Croda Corporation) was used as an additive.

**[Table 1]**

| | | Ex.1 | Ex. 2 | Ex. 3 | Ex. 4* | Comp. Ex. 1 | Comp. Ex. 2 | Comp. Ex. 3 |
|---|---|---|---|---|---|---|---|---|
| Silver powder | d50 2.0µm | 30.66 | 30.64 | 30.16 | 29.66 | 28.66 | 25.66 | 30.16 |
| | d50 0.8µm | 59.89 | 59.89 | 59.89 | 59.89 | 59.89 | 59.89 | 59.89 |
| Glass frit | Prep. Ex. 1 | - | 0.2 | 0.5 | 1 | 2 | 5 | - |
| | Prep. Ex. 2 | - | - | - | - | - | - | 0.5 |
| Binder | Ethyl cellulose | 2.15 | 2.15 | 2.15 | 2.15 | 2.15 | 2.15 | 2.15 |
| Solvent | BCA | 7.0 | 7.0 | 7.0 | 7.0 | 7.0 | 7.0 | 7.0 |
| Dispersant | KD-4 | 0.3 | 0.3 | 0.3 | 0.3 | 0.3 | 0.3 | 0.3 |

| | | | | | | | | |
|---|---|---|---|---|---|---|---|---|
| *not claimed. | | | | | | | | |

### <Example 5>

A polycrystalline silicon wafer having a thickness of 156 mm was doped with phosphorus (P) at 900°C in a tube furnace by a diffusion process using POCl₃ to form an emitter layer having 100 Ω/sq sheet resistance.

A silicon nitride film was deposited on the emitter layer by plasma enhanced chemical vapor deposition (PECVD) to form an anti-reflective coating film having a thickness of 80 µm.

The anti-reflective coating film was printed to a line width of 60 µm using etching paste (SolarEtch BES Type10, manufactured by Merck Corporation) by electrohydrodynamic (EHD) printing, and then dried at 330°C by a belt dryer. The dried wafer was immersed into a 0.1% KOH solution charged in a bath, and was then treated by ultra-sonication to remove and then dry the anti-reflective coating (ARC) film printed with the etching paste, thereby forming an opening. Subsequently, a nickel layer (that is, a first conductive layer of a front electrode) was formed in the opening using a nickel-containing conductive paste composition by electrohydrodynamic (EHD) printing. Here, the nickel-containing conductive paste composition was prepared by mixing 40 wt% of nickel particles having a particle diameter of about 50 nm, 50 wt% of ethyl cellosolve as a main solvent, 7 wt% of tripropyleneglycolmethylether as a high-boiling solvent, 1 wt% of polyvinylpyrrolidone K15 as a binder and 2 wt% of BYK996 as a dispersant for 2 hours using a ball mill.

A second conductive layer of a front electrode was formed on the formed nickel layer (that is, the first conductive layer of a front electrode) using the silver paste of Example 1 including no glass frit. Further, the back side of the wafer was screen-printed with Al paste (ALSOLAR, manufactured by Toyo Aluminium K. K Corporation). Thereafter, drying was performed at a temperature of 300°C for 60 seconds in a belt firing furnace, and then sintering was performed at a peak temperature of 850°Cf or 20 seconds in a belt firing furnace to form a first electrode (first conductive layer), a second electrode (second conductive layer) and a rear electrode. In this case, the finger width of the formed front electrode was 70 µm, and the thickness thereof was about 10 µm.

### <Example 6>

A solar cell was manufactured in the same manner as in Example 5, except that the silver paste of Example 2 was used at the time of forming the second conductive layer of a front electrode.

### <Example 7>

A solar cell was manufactured in the same manner as in Example 5, except that the silver paste of Example 3 was used at the time of forming the second conductive layer of a front electrode.

### <Example 8>

A solar cell was manufactured in the same manner as in Example 5, except that the silver paste of Example 4 was used at the time of forming the second conductive layer of a front electrode.

### <Comparative Example 4>

A solar cell was manufactured in the same manner as in Example 5, except that the silver paste of Comparative Example 1 was used at the time of forming the second conductive layer of a front electrode.

### <Comparative Example 5>

A solar cell was manufactured in the same manner as in Example 5, except that the silver paste of Comparative Example 2 was used at the time of forming the second conductive layer of a front electrode.

### <Comparative Example 6>

A solar cell was manufactured in the same manner as in Example 5, except that silver paste of Comparative Example 3 was used at the time of forming the second conductive layer of a front electrode.

### <Comparative Example 7>

A solar cell was manufactured using Sol9411 (manufactured by Heraeus Corporation) without performing an ARC grooving process and a nickel printing process in the same manner as in Example 5. This method belongs to a general solar cell manufacturing method.

### <Comparative Example 8>

A solar cell was manufactured using the silver paste of Comparative Example 2 without performing an ARC grooving process and a nickel printing process in the same manner as in Example 5. This method belongs to a general solar cell manufacturing method.

### [Experimental Example]

### Evaluation of electrical performance of solar cells

The electrical performance of the solar cells manufactured in Examples 3 to 4 and Comparative Examples 5 to 10 was measured using a solar tester (Model: NCT-M-180A, manufactured by NPC Incorporated in NJ, Dumont in U.S.A. under a solar condition of AM 1.5 according to the ASTM G-173-03. The results thereof are given in Table 2 below. Here, Jsc is a short-circuit current density measured at a zero output voltage, and Voc is an open-circuit voltage measured at a zero output current. Further, F.F.[%] is a fill factor, and Eff [%] is efficiency.

**[Table 2]**

| | Jsc [mA/cm²] | Voc [V] | F.F. [%] | Eff [%] |
|---|---|---|---|---|
| Ex. 5 | 35.25 | 0.62 | 73.1 | 16 |
| Ex. 6 | 35.12 | 0.622 | 75.7 | 16.5 |
| Ex. 7 | 35.24 | 0.621 | 76.8 | 16.8 |
| Ex. 8* | 34.41 | 0.612 | 67.8 | 14.25 |
| Comp. Ex. 4 | 34.32 | 0.607 | 55.95 | 11.7 |
| Comp. Ex. 5 | 26.32 | 0.607 | 36.15 | 5.75 |
| Comp. Ex. 6 | 34.89 | 0.584 | 44.54 | 9.08 |
| Comp. Ex. 7 | 34.29 | 0.608 | 77 | 16.1 |
| Comp. Ex. 8 | 34.86 | 0.617 | 75.35 | 16.23 |

| | | | | |
|---|---|---|---|---|
| *not claimed. | | | | |

As seen from the results of Table 2 above, when a front electrode is formed using the silver paste (Example 7) including 0.5 wt% of glass frit at the time of manufacturing a solar cell, the optimum solar cell characteristics are exhibited. Further, due to the formation of a nickel (Ni) electrode layer, the contact between a silicon wafer and a silver (Ag) electrode become easy, thus exhibiting low contact resistance. For this reason, the amount of glass frit is minimized to allow a solar cell to have high Jsc and F.F. values. In a shallow emitter, the properties and content of glass frit are important. When the properties and content of glass frit are excessive, an emitter layer is punched through to be shunted, thus having a great influence on F.F. Further, since this basic process is a process of removing anti-reflective coating (ARC) film and introducing a silicide layer, the content of glass frit, which is a non conductor, can be reduced, and thus it is possible to manufacture a solar cell having excellent cell characteristics.

Further, in the case of the silver paste of Example 5 including no glass frit, it can be ascertained that the efficiency of a solar cell is exhibited to some degree even when this silver paste does not include glass frit. Further, in the case of the silver paste of Example 5 including 0.2 wt% of glass frit, it can be ascertained that its effect is very excellent. The results of the silver paste of Example 8 are somewhat inferior to those of the silver pastes of Comparative Examples 7 and 8, but it can be ascertained that its glass frit content is relatively low and is minimized to such a degree that the efficiency of a solar cell can be exhibited.

## Claims

1. A method of manufacturing an electrode of a solar cell, comprising the steps of:
forming an emitter layer (2) on a substrate (1);
forming an anti-reflective coating film (3) on the emitter layer (2);
removing a partial region of the anti-reflective coating film (3) to form an opening;
forming a first conductive layer (4) directly connected with the emitter layer (2) in the opening of the anti-reflective coating film (3); and
forming a second conductive layer (5) on the first conductive layer (4),
wherein the second conductive layer (5) is formed by printing a conductive paste composition on the first conductive layer (4), wherein the conductive paste composition includes 60 to 95 wt% of metal powder, 0 to 0.5 wt% of glass frit, 1 to 20 wt% of a binder and 1 to 20 wt% of a solvent,
wherein the glass frit have an average particle diameter (D₅₀) of 0.5 to 10 µm,
wherein the metal particles of the second conductive layer (5) are included in the first conductive layer (4) in an amount of 2 to 10 parts by weight, based on 100 parts by weight of the metal particles of the first conductive layer (4),
wherein the metal powder includes metal particles having an average particle diameter (D₅₀) of 0.5 to 4 µm, selected from the group consisting of Ag, Au, Al, Ni, Pt, Cu, and alloys thereof.

2. The method of claim 1, wherein the metal powder includes sphere-shaped or flake-shaped Ag powder having an average particle diameter (D₅₀) of 0.5 to 4 µm.

3. The method of claim 1, wherein the glass frit includes 5 to 30 wt% of SiO₂, 50 to 90 wt% of PbO, 0.1 to 10 wt% of Al₂O₃ and 0.1 to 10 wt% of ZrO₂.

4. The method of claim 1, wherein the glass frit includes 5 to 30 wt% of SiO₂, 50 to 90 wt% of PbO, 0.1 to 10 wt% of Al₂O₃ and 0.1 to 10 wt% of ZrO₂, 0.1 to 10 wt% of ZnO and 0.1 to 10 wt% of Li₂O.

5. The method of claim 1, wherein the binder includes:
a carboxyl-containing photosensitive resin which is a copolymer of an unsaturated carboxylic compound and a compound having an unsaturated double bond;
a carboxyl-containing photosensitive resin which obtained by adding an ethylenically unsaturated group, as a pendant group, to a copolymer of an unsaturated carboxylic compound and a compound having an unsaturated double bond; and
a carboxyl-containing photosensitive resin which obtained by a reaction of a copolymer of an unsaturated carboxylic compound and a compound having an unsaturated double bond with a compound having a hydroxyl group and an unsaturated double bond.

6. The method of claim 1, wherein the solvent includes at least one selected from the group consisting of α-terpineol, butyl carbitol acetate, texanol, butyl carbitol, and dipropylene glycol monomethyl ether.

7. The method of claim 1, wherein the second conductive layer (5) is formed by electrohydrodynamic printing, screen printing, inkjet printing, dispensing printing or plating.

8. The method of claim 1, wherein the first conductive layer (4) is a metal silicide layer including metal particles selected from the group consisting of Ni, Ti, Co, Pt, Pd, Mo, Cr, Cu, W, and alloys thereof.

9. The method of claim 1, further comprising the step of performing a firing process at a temperature of 400°C to 980°C for 0.1 to 20 min after the formation of the first conductive layer (4) and the second conductive layer (5).

10. The method of claim 1, wherein the opening is formed by photolithography, laser etching or an etching paste method.

## Patentansprüche

1. Verfahren zur Herstellung einer Elektrode einer Solarzelle, das die folgenden Schritte umfasst:
Ausbilden einer Emitterschicht (2) auf einem Substrat (1);
Ausbilden eines antireflektierenden Beschichtungsfilms (3) auf der Emitterschicht (2); Entfernen eines Teilbereichs des antireflektierenden Beschichtungsfilms (3) zum Ausbilden einer Öffnung;
Ausbilden einer ersten leitfähigen Schicht (4), die direkt mit der Emitterschicht (2) in der Öffnung des antireflektierenden Beschichtungsfilms (3) verbunden ist; und
Ausbilden einer zweiten leitfähigen Schicht (5) auf der ersten leitfähigen Schicht (4),
wobei die zweite leitfähige Schicht (5) durch Drucken einer leitfähigen Pastenzusammensetzung auf die erste leitfähige Schicht (4) ausgebildet wird, wobei die leitfähige Pastenzusammensetzung 60 bis 95 Gew.-% Metallpulver, 0 bis 0,5 Gew.-% Glasfritte, 1 bis 20 Gew.-% eines Bindemittels und 1 bis 20 Gew.-% eines Lösungsmittels enthält,
wobei die Glasfritte einen durchschnittlichen Teilchendurchmesser (D₅₀) von 0,5 bis 10 µm aufweist,
wobei die Metallteilchen der zweiten leitfähigen Schicht (5) in der ersten leitfähigen Schicht (4) in einer Menge von 2 bis 10 Gewichtsteilen, bezogen auf 100 Gewichtsteile der Metallteilchen der ersten leitfähigen Schicht (4), enthalten sind,
wobei das Metallpulver Metallteilchen mit einem durchschnittlichen Teilchendurchmesser (D₅₀) von 0,5 bis 4 µm enthält, die aus der Gruppe ausgewählt sind, die aus Ag, Au, Al, Ni, Pt, Cu und deren Legierungen besteht.

2. Verfahren nach Anspruch 1, wobei das Metallpulver kugelförmiges oder flockenförmiges Ag-Pulver mit einem durchschnittlichen Teilchendurchmesser (D₅₀) von 0,5 bis 4 µm enthält.

3. Verfahren nach Anspruch 1, wobei die Glasfritte 5 bis 30 Gew.-% SiO₂, 50 bis 90 Gew.-% PbO, 0,1 bis 10 Gew.-% Al₂O₃ und 0,1 bis 10 Gew.-% ZrO₂ enthält.

4. Verfahren nach Anspruch 1, wobei die Glasfritte 5 bis 30 Gew.-% SiO₂, 50 bis 90 Gew.-% PbO, 0,1 bis 10 Gew.-% Al₂O₃ und 0,1 bis 10 Gew.-% ZrO₂, 0,1 bis 10 Gew.-% ZnO und 0,1 bis 10 Gew.-% Li₂O enthält.

5. Verfahren nach Anspruch 1, wobei das Bindemittel enthält:
ein carboxylhaltiges lichtempfindliches Harz, das ein Copolymer aus einer ungesättigten Carboxylverbindung und einer Verbindung mit einer ungesättigten Doppelbindung ist;
ein carboxylhaltiges lichtempfindliches Harz, das durch Hinzufügen einer ethylenisch ungesättigten Gruppe als Seitengruppe zu einem Copolymer aus einer ungesättigten Carboxylverbindung und einer Verbindung mit einer ungesättigten Doppelbindung erhalten wird; und
ein carboxylhaltiges lichtempfindliches Harz, das durch eine Reaktion eines Copolymers aus einer ungesättigten Carboxylverbindung und einer Verbindung mit einer ungesättigten Doppelbindung mit einer Verbindung mit einer Hydroxylgruppe und einer ungesättigten Doppelbindung erhalten wird.

6. Verfahren nach Anspruch 1, wobei das Lösungsmittel mindestens eines umfasst, das aus der Gruppe ausgewählt ist, die aus α-Terpineol, Butylcarbitolacetat, Texanol, Butylcarbitol und Dipropylenglykolmonomethylether besteht.

7. Verfahren nach Anspruch 1, wobei die zweite leitfähige Schicht (5) durch elektrohydrodynamischen Druck, Siebdruck, Tintenstrahldruck, Spenderdruck oder Galvanisieren ausgebildet wird.

8. Verfahren nach Anspruch 1, wobei die erste leitfähige Schicht (4) eine Metallsilicidschicht ist, die Metallteilchen enthält, die aus der Gruppe ausgewählt sind, die aus Ni, Ti, Co, Pt, Pd, Mo, Cr, Cu, W und deren Legierungen besteht.

9. Verfahren nach Anspruch 1, das ferner den Schritt des Durchführens eines Brennprozesses bei einer Temperatur von 400 °C bis 980 °C für 0,1 bis 20 Minuten nach dem Ausbilden der ersten leitfähigen Schicht (4) und der zweiten leitfähigen Schicht (5) umfasst.

10. Verfahren nach Anspruch 1, wobei die Öffnung durch Photolithographie, Laserätzen oder ein Ätzpastenverfahren ausgebildet wird.

## Revendications

1. Procédé de fabrication d'une électrode d'une cellule solaire, comprenant les étapes de :
la formation d'une couche émettrice (2) sur un substrat (1) ;
la formation d'un fil de revêtement antireflet (3) sur la couche émettrice (2) ;
l'élimination d'une région partielle du film de revêtement antireflet (3) pour former une ouverture ;
la formation d'une première couche conductrice (4) directement reliée à la couche émettrice (2) dans l'ouverture du film de revêtement antireflet (3) ; et
la formation d'une deuxième couche conductrice (5) sur la première couche conductrice (4),
la deuxième couche conductrice (5) étant formée par impression d'une composition de pâte conductrice sur la première couche conductrice (4), la composition de pâte conductrice comportant 60 à 95 % en poids de poudre métallique, 0 à 0,5 % en poids de fritte de verre, 1 à 20 % en poids d'un liant et 1 à 20 % en poids d'un solvant,
la fritte de verre possédant un diamètre moyen de particule (D₅₀) de 0,5 à 10 µm,
les particules métalliques de la deuxième couche conductrice (5) étant incluses dans la première couche conductrice (4) en une quantité de 2 à 10 parties en poids, sur la base de 100 parties en poids des particules métalliques de la première couche conductrice (4),
la poudre métallique comportant des particules métalliques possédant un diamètre moyen de particule (D₅₀) de 0,5 à 4 µm, choisies dans le groupe constitué par Ag, Au, Al, Ni, Pt, Cu et des alliages correspondants.

2. Procédé selon la revendication 1, la poudre métallique comportant une poudre d'Ag en forme de sphère ou en forme de paillettes possédant un diamètre moyen de particule (D₅₀) de 0,5 à 4 µm.

3. Procédé selon la revendication 1, la fritte de verre comportant 5 à 30 % en poids de SiO₂, 50 à 90 % en poids de PbO, 0,1 à 10 % en poids de Al₂O₃ et 0,1 à 10 % en poids de ZrO₂.

4. Procédé selon la revendication 1, la fritte de verre comportant 5 à 30 % en poids de SiO₂, 50 à 90 % en poids de PbO, 0, 1 à 10 % en poids de Al₂O₃, 0,1 à 10 % en poids de ZrO₂, 0,1 à 10 % en poids de ZnO et 0,1 à 10 % en poids de Li₂O.

5. Procédé selon la revendication 1, le liant comprenant :
une résine photosensible contenant carboxyle qui est un copolymère d'un composé carboxylique insaturé et d'un composé possédant une double liaison insaturée ;
une résine photosensible contenant carboxyle qui est obtenue en ajoutant un groupe éthyléniquement insaturé, en tant que groupe pendant, à un copolymère d'un composé carboxylique insaturé et d'un composé possédant une double liaison insaturée ; et
une résine photosensible contenant carboxyle qui est obtenue par une réaction d'un copolymère d'un composé carboxylique insaturé et d'un composé possédant une double liaison insaturée avec un composé possédant un groupe hydroxyle et une double liaison insaturée.

6. Procédé selon la revendication 1, le solvant comprenant au moins l'un choisi dans le groupe constitué par le α-terpinéol, l'acétate de butylcarbitol, le texanol, le butylcarbitol, et le monométhyléther de dipropylèneglycol.

7. Procédé selon la revendication 1, la deuxième couche conductrice (5) étant formée par impression électrohydrodynamique, sérigraphie, impression par jet d'encre, impression par distribution ou placage.

8. Procédé selon la revendication 1, la première couche conductrice (4) étant une couche de siliciure métallique comportant des particules métalliques choisies dans le groupe constitué par Ni, Ti, Co, Pt, Pd, Mo, Cr, Cu, W, et des alliages correspondants.

9. Procédé selon la revendication 1, comprenant en outre l'étape de réalisation d'un procédé de cuisson à une température de 400 °C à 980 °C pendant 0,1 à 20 min après la formation de la première couche conductrice (4) et de la deuxième couche conductrice (5) .

10. Procédé selon la revendication 1, l'ouverture étant formée par photolithographie, gravure laser ou un procédé à pâte de gravure.
